# EUROPEAN PATENT SPECIFICATION

(11) **EP 3 957 142 B1**
(45) Date of publication and mention of the grant of the patent: **18.06.2025**
(21) Application number: 20725922.7
(22) Date of filing: 17.04.2020
(51) Int. Cl.: H05K 7/20

(54) **ELECTRONIC POWER CONVERSION APPARATUS FOR ELECTRIC OR HYBRID VEHICLES**
ELEKTRONISCHE LEISTUNGSUMWANDLUNGSVORRICHTUNG FÜR ELEKTRO- ODER HYBRIDFAHRZEUGE
APPAREIL DE CONVERSION DE PUISSANCE ÉLECTRONIQUE POUR VÉHICULES ÉLECTRIQUES OU HYBRIDES

(30) Priority: 19.04.2019 IT 201900006190
(43) Date of publication of application: 23.02.2022
(73) Proprietor: Meta System S.p.A., 42124 Reggio Emilia (IT)
(72) Inventor: LASAGNI, Cesare, 42124 Reggio Emilia (RE) (IT)
(74) Representative: Grana, Daniele
(86) International application number: PCT/IB2020/053644
(87) International publication number: WO 2020/212921

(56) References cited:
- EP-A1- 2 346 152
- DE-A1- 102010 014 752
- FR-A1- 2 962 072
- US-A- 5 624 003
- US-A1- 2013 235 527

## Description

### Technical Field

The present invention relates to an electronic power conversion apparatus for electric or hybrid vehicles, of the type of an On-Board Charger (OBC) or DC-DC converter that can be installed in an electric or hybrid vehicle and connectable to the vehicle's electric battery.

### Background Art

With reference to the electric or hybrid vehicle sector, it is essential to use electronic power apparatuses installed on board vehicles for the conversion of an input voltage/current into an output voltage/current, such as OBC (On-Board Chargers) or DC-DC converters.

Such apparatuses commonly comprise power electronics that require a dedicated cooling system capable of maintaining the temperature at acceptable levels during use.

Commonly, the electronics of energy conversion apparatuses of known type is enclosed within a metal enclosure, preferably made entirely of aluminum. Specifically, the aluminum enclosure is used to allow effective heat dissipation by air dissipation during energy conversion.

In addition, the apparatuses of known type commonly comprise a fluid cooling circuit made at the point where a portion of the enclosure is located and used to cool part of the internal electronics.

In particular, the apparatuses of known type comprise a cooling chamber, made at the point where a portion of the enclosure is located, provided with an inlet and an outlet for the coolant, and provided with at least one wall or portion of surface placed in contact with the electronics to be cooled.

This way, the inlet and continuous change of the coolant inside the chamber allows the electronics to be kept at a suitable temperature.

Always with reference to the automotive sector and in particular with reference to the electric or hybrid vehicles, the use is also known of battery heating apparatuses.

In fact, in case of very low outdoor temperatures, it is essential to heat the vehicle battery to ensure optimal operation. In fact, it is well known that this type of battery is very sensitive to temperature (both low and high) and, below zero, it has very low performance.

Such heaters are generally connected to a dedicated battery heating/cooling circuit and are adapted to be operated when necessary to heat the fluid inside the circuit.

Therefore, such heaters generally use a special heating circuit and are operated to bring the battery to the optimum temperature or, in any case, above the minimum temperature that can ensure the correct operation of the battery.

The known solutions do, however, have some drawbacks.

In fact, the obligation by car manufacturers to guarantee the correct operation of the battery, and therefore of the vehicle, in all weather conditions, in the presence of high temperatures but also in the presence of temperatures well below zero, requires the simultaneous use of special systems and apparatuses dedicated to cool and heat the battery itself.

Consequently, the use of such cooling and heating systems ends up increasing the overall costs of the vehicle, as well as the complexity of installation, the overall dimensions, the complexity of the control electronics, and the maintenance costs of such systems.

In particular, the heaters of known type are generally expensive with large overall dimensions.

Documents US 5 624 003 A, FR 2 962 072 A1 and DE 10 2010 014752 A1 disclose battery heating devices for an electric vehicle,

### Description of the Invention

The main aim of the present invention is to devise an electronic power conversion apparatus for electric or hybrid vehicles that allows reducing the overall costs for the vehicle's construction.

Another object of the present invention is to devise an electronic power conversion apparatus for electric or hybrid vehicles that allows overcoming the aforementioned drawbacks of the prior art within a simple, rational, easy and effective solution.

The aforementioned objects are achieved by the present electronic power conversion apparatus for electric or hybrid vehicles according to claim 1.

### Brief Description of the Drawings

Other characteristics and advantages of the present invention will be more evident from the description of two possible preferred, but not exclusive, embodiments of an electronic power conversion apparatus for electric or hybrid vehicles, illustrated by way of an indicative, but non-limiting example, in the attached tables of drawings in which:
Figures 1, 2 and 3 show a possible first embodiment of the apparatus according to the invention;
Figures 4 and 5 show a possible second embodiment of the apparatus according to the invention.

### Embodiments of the Invention

With particular reference to these figures, reference numeral 1 globally indicates an electronic power conversion apparatus for electric or hybrid vehicles.

In particular, according to a possible embodiment, the apparatus 1 is composed of an OBC (On-Board Charger) installable on an electric or hybrid vehicle and connectable to the vehicle's electric battery.

In addition, according to a further possible embodiment, the apparatus 1 is composed of a DC/DC converter installable on an electric or hybrid vehicle and connectable to the vehicle's electric battery.

The apparatus 1 comprises at least one external enclosure 2 and at least one electronic circuit 3 housed inside the enclosure 2 and connectable to the vehicle's battery.

The electronic circuit 3 is configured for the conversion of an input current/voltage into a predefined output current/voltage. In particular, the electronic circuit 3 can consist of one or more power or control electronic boards of the type conventionally used in OBC (On-Board Charger) or DC-DC converters installable on an electric or hybrid vehicle.

The apparatus 1 may be provided with at least one lid 4 for closing the enclosure 2.

In addition, the apparatus 1 comprises at least one liquid cooling chamber 5 obtained at a portion of the enclosure 2 and adapted to allow the cooling of the electronic circuit 3.

The cooling chamber 5 is provided with a liquid inlet port 6 and with a liquid outlet port 7.

The cooling chamber 6 is also provided with at least one wall or portion of surface 8', 8" positioned in contact with the electronic circuit 3 to be cooled.

This way, the inlet and continuous change of the liquid inside the cooling chamber 5 allows the electronic circuit 3 to be kept at a suitable temperature.

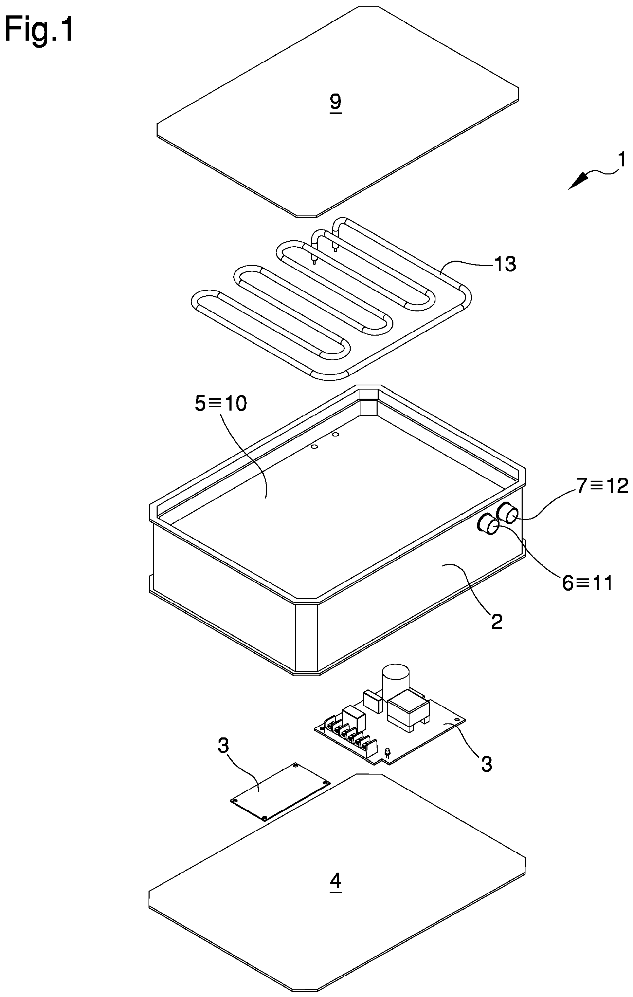

With reference to a possible first embodiment, illustrated by way of example in Figures 1, 2 and 3, the cooling chamber 5 is composed of a hollow portion of the enclosure 2 itself, which is hermetically sealed by means of a closing plate 9.

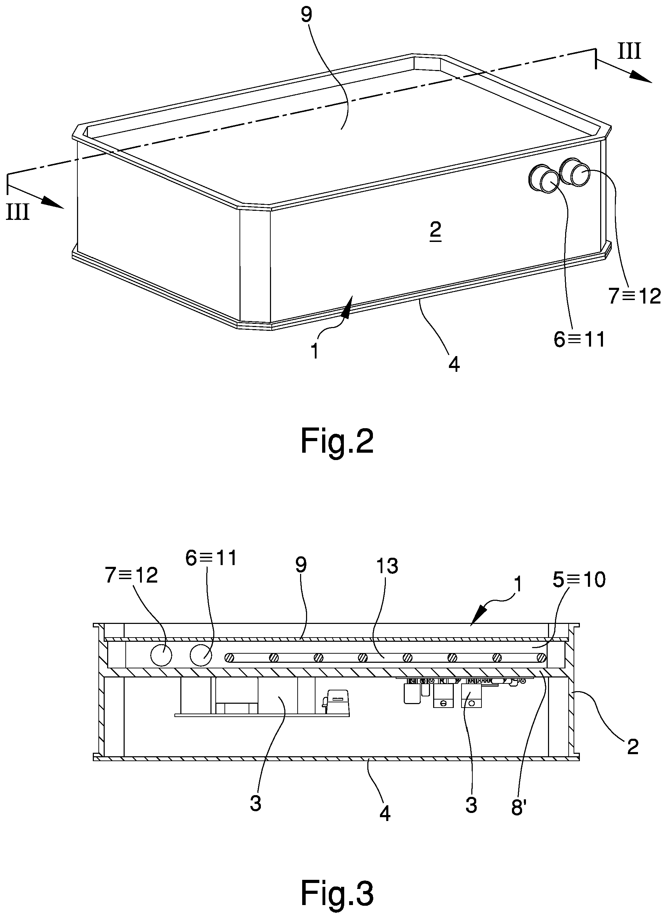

Always according to this embodiment and as shown in detail in Figure 3, the cooling chamber 5 is composed of a wall 8' placed in contact with one or more electronic components of the electronic circuit 3 to be cooled.

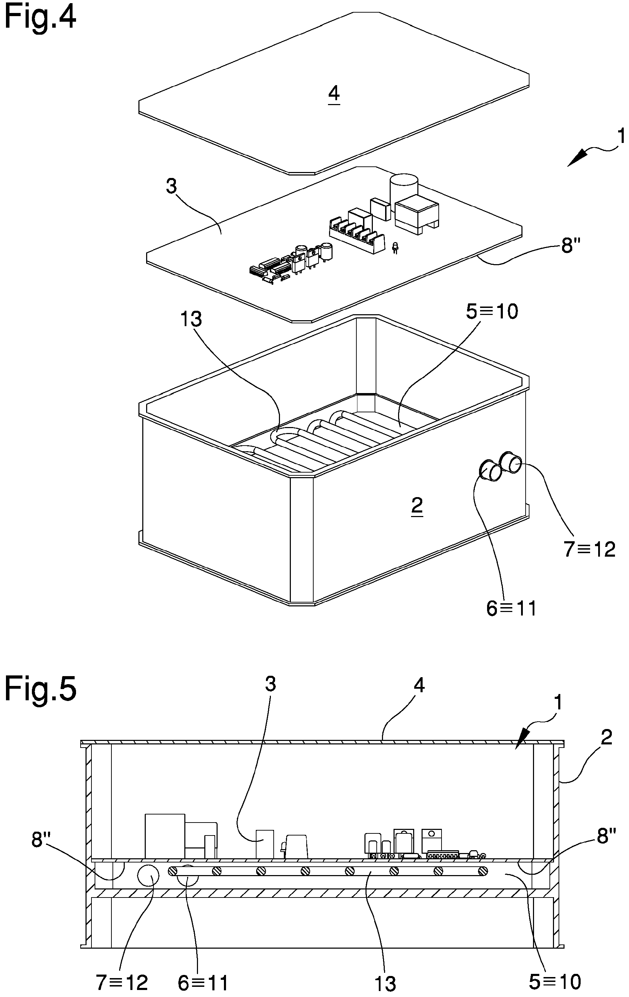

With reference, on the other hand, to a possible second embodiment, illustrated by way of example in Figures 4 and 5, the cooling chamber 5 is composed of a hollow portion of the enclosure 2 itself, which is hermetically sealed by the same support 8" of the electronic circuit 3, made according to IMS (Insulated Metal Substrate) technology.

In this case, therefore, the liquid circulating inside the cooling chamber 5 is in direct contact with the aluminum base of the same electronic circuit 3 of the IMS type.

Different embodiments of the cooling chamber 5 cannot however be ruled out. Advantageously, the main and innovative feature of the apparatus 1 according to the invention consists in that the apparatus 1 itself comprises at least one heating chamber 10 made at the point where at least one portion of the enclosure 2 is located and provided with at least one inlet port 11 of a fluid and at least one outlet port 12 of the fluid. The inlet port 11 and the outlet port 12 of the heating chamber 10 are connected to a heating circuit of the vehicle's battery.

In addition, the apparatus 1 comprises heating means 13 housed inside the heating chamber 10 and adapted to heat the fluid circulating inside the heating chamber itself.

Advantageously, this way the same apparatus 1 can be used to heat the vehicle's battery, instead of the traditional heating apparatuses.

In fact, in case of need, i.e. if the outside temperature drops below a predefined minimum temperature, the operation of the heating means 13 allows the heating of the fluid circulating inside the heating chamber 10, this fluid then reaching the battery by means of the special heating circuit connected to the outlet port 12.

Therefore, the apparatus 1 according to the invention can be used to bring the battery of an electric or hybrid vehicle to the optimal temperature or, in any case, above the minimum temperature that can ensure the correct operation of the battery itself.

With reference to a preferred embodiment of the apparatus 1, illustrated in the figures, the heating chamber 10 coincides with the cooling chamber 5 of the apparatus itself, while the inlet port 6 and the outlet port 7 coincide with the inlet port 11 and with the outlet port 12.

In actual facts, therefore, the inlet port 6, 11 and the outlet port 7, 12 are connectable to a temperature conditioning circuit of a vehicle's battery which can be used both for heating and for cooling the battery itself.

In fact, the apparatus 1, being an apparatus of the type of an OBC (On-Board Charger) or a DC-DC converter normally installed on board a vehicle and normally connected to the circuit conventionally used to cool the vehicle's battery, can advantageously use the same circuit also as a battery heating circuit. In addition, the fact that the apparatus 1 is provided with a single chamber 5, 10 which can be used both as cooling chamber 5 and as heating chamber 10, makes it possible to reduce the size of the apparatus 1 considerably.

In particular, the apparatus 1 allows integrating all the electronics and functions performed by a conventional heating apparatus of known type inside an OBC (On-Board Charger) or a DC-DC converter of conventional size. This allows for a considerable reduction of the overall dimensions inside the vehicle.

The heating means 13 comprises at least one heating element 13 housed inside the heating chamber 10 and operationally connected to the electronic circuit 3. With reference to a preferred embodiment, shown in the figures, the heating means 13 are composed of a single heating element extending inside the heating chamber 10 along a predefined path.

Preferably, this heating element 13 comprises at least one electrical resistor. Specifically, the heating element 13 is composed of a heating coil.

Different embodiments cannot however be ruled out. For example, the coil can be replaced by other types of heating elements such as deposited resistance or the like.

Advantageously, the electronic circuit 3, which has already been used for power conversion, can also be partly used to adjust the power of the heating element 13 itself. In particular, input-output connectors, microcontroller or control DSP, auxiliary power supply circuits, input and/or output filter, and other components or devices can be considered as having a similar function.

It has in practice been ascertained that the described invention achieves the intended objects.

In particular, it is underlined that the apparatus according to the invention allows reducing the overall manufacturing costs of the vehicle.

Specifically, the apparatus according to the invention, in addition to performing the functions normally carried out by a conventional OBC (On-Board Charger) or by a DC-DC converter, also allows controlling the heating of the battery in case of need.

## Claims

1. Electronic power conversion apparatus (1) for electric or hybrid vehicles, connectable to at least one battery of an electric or hybrid vehicle, comprising:
- at least one external enclosure (2);
- at least one electronic circuit (3) housed inside said enclosure (2), connectable to said battery and configured for the conversion of an input current/voltage into a predefined output current/voltage;
- at least one liquid cooling chamber (5) made at a portion of said enclosure (2) for cooling said electronic circuit (3);
- at least one heating chamber (10) made at at least one portion of said enclosure (2) and provided with at least one inlet port (11) of a fluid and at least one outlet port (12) of said fluid, said inlet port (11) and said outlet port (12) being connected to a heating circuit of said battery,
**characterized in that** the apparatus comprises heating means (13) of the fluid inside said heating chamber (10),
**in that** said heating means (13) comprise at least one heating element (13) housed inside said heating chamber (10) and operationally connected to said electronic circuit (3), and
**in that** said heating element (13) comprises at least one electrical resistor and/or at least one heating coil and **in that** said electronic circuit (3) comprises management and control means of said heating element (13).

2. Apparatus (1) according to claim 1, **characterized by** the fact that said heating element (13) extends inside said heating chamber (10) along a predefined path.

3. Apparatus (1) according to one or more of the preceding claims, **characterized by** the fact that said heating chamber (10) coincides with said cooling chamber (5), said inlet port (11) and said outlet port (12) being connectable to a temperature conditioning circuit of said battery which can be used both for heating and for cooling said battery.

4. Apparatus (1) according to one or more of the preceding claims, **characterized by** the fact that it is composed of an OBC battery charger.

5. Apparatus (1) according to one or more of the preceding claims, **characterized by** the fact that it is composed of a DC/DC converter.

## Patentansprüche

1. Elektronische Leistungsumwandlungsvorrichtung (1) für Elektro- oder Hybridfahrzeuge, die an mindestens eine Batterie eines Elektro- oder Hybridfahrzeugs anschließbar ist, umfassend:
- mindestens ein externes Gehäuse (2);
- mindestens eine elektronische Schaltung (3), die in dem Gehäuse (2) untergebracht ist, mit der Batterie verbindbar ist und zur Umwandlung eines Eingangsstroms/ einer Eingangsspannung in einen vorgegebenen Ausgangsstrom/ eine vorgegebene Ausgangsspannung ausgebildet ist;
- mindestens eine Flüssigkeitskühlkammer (5), die an einem Teil des Gehäuses (2) ausgebildet ist, um die elektronische Schaltung (3) zu kühlen;
- mindestens eine Heizkammer (10), die an mindestens einem Teil des Gehäuses (2) ausgebildet und mit mindestens einer Einlassöffnung (11) für ein Fluid und mindestens einer Auslassöffnung (12) für das Fluid versehen ist, wobei die Einlassöffnung (11) und die Auslassöffnung (12) mit einem Heizkreis der Batterie verbunden sind,
**dadurch gekennzeichnet, dass** die Vorrichtung Heizmittel (13) für das Fluid innerhalb der Heizkammer (10) umfasst,
dass die Heizmittel (13) mindestens ein Heizelement (13) umfassen, das innerhalb der Heizkammer (10) untergebracht und mit der elektronischen Schaltung (3) wirkverbunden ist, und
dass das Heizelement (13) mindestens einen elektrischen Widerstand und/oder mindestens eine Heizspirale umfasst und dass die elektronische Schaltung (3) Mittel zum Steuern und Regeln des Heizelements (13) umfasst.

2. Vorrichtung (1) nach Anspruch 1, **dadurch gekennzeichnet, dass** sich das Heizelement (13) innerhalb der Heizkammer (10) entlang eines vorgegebenen Pfads erstreckt.

3. Vorrichtung (1) nach einem oder mehreren der vorhergehenden Ansprüche, **dadurch gekennzeichnet, dass** die Heizkammer (10) mit der Kühlkammer (5) zusammenfällt, wobei die Einlassöffnung (11) und die Auslassöffnung (12) an einen Temperaturregelkreis der Batterie anschließbar sind, der sowohl zum Heizen als auch zum Kühlen der Batterie verwendet werden kann.

4. Vorrichtung (1) nach einem oder mehreren der vorhergehenden Ansprüche, **dadurch gekennzeichnet, dass** sie aus einem OBC-Batterieladegerät besteht.

5. Vorrichtung (1) nach einem oder mehreren der vorhergehenden Ansprüche, **dadurch gekennzeichnet, dass** sie aus einem DC/DC-Wandler besteht.

## Revendications

1. - Appareil de conversion de puissance électronique (1) pour véhicules électriques ou hybrides, pouvant être connecté à au moins une batterie d'un véhicule électrique ou hybride, comprenant :
- au moins une enceinte externe (2) ;
- au moins un circuit électronique (3) logé à l'intérieur de ladite enceinte (2), pouvant être connecté à ladite batterie et configuré pour la conversion d'un courant/d'une tension d'entrée en un courant/une tension de sortie prédéfini(e) ;
- au moins une chambre de refroidissement de liquide (5) réalisée à une partie de ladite enceinte (2) pour refroidir ledit circuit électronique (3) ;
- au moins une chambre de chauffage (10) réalisée à au moins une partie de ladite enceinte (2) et comportant au moins un orifice d'entrée (11) d'un fluide et au moins un orifice de sortie (12) dudit fluide, ledit orifice d'entrée (11) et ledit orifice de sortie (12) étant connectés à un circuit de chauffage de ladite batterie,
**caractérisé par le fait que** l'appareil comprend des moyens de chauffage (13) du fluide à l'intérieur de ladite chambre de chauffage (10),
**par le fait que** lesdits moyens de chauffage (13) comprennent au moins un élément chauffant (13) logé à l'intérieur de ladite chambre de chauffage (10) et connecté de manière fonctionnelle audit circuit électronique (3), et
**par le fait que** ledit élément chauffant (13) comprend au moins une résistance électrique et/ou au moins un serpentin de chauffage, et **par le fait que** ledit circuit électronique (3) comprend des moyens de gestion et de commande dudit élément chauffant (13).

2. - Appareil (1) selon la revendication 1, **caractérisé par le fait que** ledit élément chauffant (13) s'étend à l'intérieur de ladite chambre de chauffage (10) le long d'un trajet prédéfini.

3. - Appareil (1) selon une ou plusieurs des revendications précédentes, **caractérisé par le fait que** ladite chambre de chauffage (10) coïncide avec ladite chambre de refroidissement (5), ledit orifice d'entrée (11) et ledit orifice de sortie (12) étant aptes à être connectés à un circuit de conditionnement de température de ladite batterie qui peut être utilisé à la fois pour chauffer et pour refroidir ladite batterie.

4. - Appareil (1) selon une ou plusieurs des revendications précédentes, **caractérisé par le fait qu'**il est composé d'un chargeur de batterie embarqué (OBC).

5. - Appareil (1) selon une ou plusieurs des revendications précédentes, **caractérisé par le fait qu'**il est composé d'un convertisseur CC/CC.
